(19)

**Europäisches Patentamt**
**European Patent Office**
**Office européen des brevets**

(11) **EP 2 704 547 A2**

(12) **EUROPEAN PATENT APPLICATION**

(43) Date of publication:
**05.03.2014 Bulletin 2014/10**

(51) Int Cl.:
**H05K 9/00** (2006.01)

(21) Application number: **13181455.0**

(22) Date of filing: **23.08.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **27.08.2012 CN 201210309494**

(71) Applicant: **General Electric Company**
**Schenectady, New York 12345 (US)**

(72) Inventors:
• **SHEN, Jie**
**85748 Munich (DE)**

• **WANG, Jun**
**Schenectady, NY New York 12345 (US)**
• **SCHROEDER, Stefan**
**85748 Munich (DE)**
• **ZHANG, Fan**
**201203 Shanghai (CN)**

(74) Representative: **Serjeants LLP**
**25 The Crescent**
**King Street**
**Leicester, LE1 6RX (GB)**

(54) **Shielding Structure for Power Conversion System and Method Thereof**

(57) An exemplary electromagnetic shielding structure (150) is provided. The electromagnetic shielding structure (150) includes a first shielding material (152) disposed at a first location with respect to at least one radiation source and a second shielding material (154) attached with the first shielding material (152) by fastening means (155-157). The second shielding material (154) is disposed at a second location with respect to the at least one electromagnetic radiation source so as to define a predetermined gap between the first shielding material (152) and the second shielding material (154). The first shielding material (152) shields at least part of first frequency electromagnetic radiations generated from the at least one electromagnetic radiation source and penetrating through the second shielding material (154) and the predetermined gap. The second shielding material (154) shields at least part of second frequency electromagnetic radiations generated from the at least one electromagnetic radiation source.

FIG. 2

EP 2 704 547 A2

**Description**

BACKGROUND

Embodiments of the disclosure relate generally to shielding structures for power conversion systems and methods thereof.

Converters, particularly multi-level converters, are increasingly used for performing power conversion in a wide range of applications due to high power quality waveform and high voltage capability. For example, multi-level converters may be used to perform DC-to-AC power conversion to supply single-phase or multi-phase AC voltages to electric motors in vehicles and pumps. Multi-level converters may also be used in power generation systems such as wind turbine generators and solar panels to perform DC-to-AC power conversion to supply single-phase or multi-phase AC voltages for power grid transmission and distribution.

Typically, the converter is operated to provide single-phase or multi-phase output such as alternating current output by selectively switching on and off a plurality of semiconductor-based switching devices such as IGBTs and IGCTs in accordance with pulse signals having predetermined pulse patterns or sequences. Ideally, it is desirable to provide the single-phase or multi-phase output having a perfect waveform such as a perfect sinusoidal waveform. However, the switching operations of these switching devices will always create one or more harmonic components superimposed in the fundamental components. When the fundamental components as well as the harmonic components are transmitted to a load via one or more conduction paths such as bus-bar, electromagnetic emissions will emit from the one or more conduction paths and propagate in the space to the surrounding environment, which may cause electromagnetic interference with one or more other electrical components. To meet at least some industrial safety standards which may specify the amount of electromagnetic radiations that are allowed to be emitted, constructing a cabinet or enclosure having a material made from steel is a typical solution for shielding or suppressing the electromagnetic radiations to an acceptable level. As is known, the steel material made cabinet is operated to suppress the electromagnetic radiations by at least partially converting the electromagnetic energy to thermal energy (or referred to as thermal loss) through eddy current induced from the electromagnetic radiations. Due to the skin effect, the induced eddy current tends to concentrate on the inner surface of the cabinet when the frequency of the electromagnetic radiations is increased. Thus, one problem associated with the conventional solution of electromagnetic radiations shielding is that when the frequency of electromagnetic radiations is increased in a high frequency range, a greater thermal loss may be generated at the cabinet which may cause a significant temperature rise at the cabinet. Without an upgraded cooling system having a sufficient cooling capacity, an operator assigned to perform various tasks with respect to the cabinet or one or more components inside of the cabinet may be hurt or damaged by a hot cabinet. Furthermore, the problem may become even critical when the converter is operated to provide high current outputs, because stronger electromagnetic radiations can be generated due to the high current outputs, and thus greater induced eddy current and more thermal loss are generated at the cabinet.

Therefore, it is desirable to provide systems and methods with improved shielding structures to address one or more of the above-mentioned issues of the current systems and methods.

BRIEF DESCRIPTION

In accordance with one aspect of the present disclosure, a system for driving an AC electric motor is provided. The system includes a converter and a cabinet. The converter is capable of being operated to perform power conversion and provide at least a first phase AC current output to a first winding of the AC electric motor via a first conduction path, a second phase AC current output to a second winding of the AC electric motor via a second conduction path, and a third phase AC current output to a third winding of the AC electric motor via a third conduction path. The cabinet is used for accommodating the converter therein. The cabinet includes a first shielding member and a second shielding member. The first shielding member is disposed on at least one side of the cabinet. The first shielding member is capable of absorbing at least a part of first frequency electromagnetic radiations generated from at least one of the first phase AC current flowing through the first conduction path, the second phase AC current flowing through the second conduction path, and the third phase AC current flowing through the third conduction path. The second shielding member is disposed adjacent to the first shielding member. The second shielding member is capable of absorbing at least a part of second frequency electromagnetic radiations generated from at least one of the first phase AC current flowing through the first conduction path, the second phase AC current flowing through the second conduction path, and the third phase AC current flowing through the third conduction path.

In accordance with another aspect of the present disclosure, a method of shielding electromagnetic radiations is provided. The electromagnetic radiations are generated from at least one electromagnetic radiation source in association with a converter accommodated within a cabinet. The method includes at least the following steps: providing a first shielding material at one side of the cabinet for shielding first frequency electromagnetic radiations generated from the at least one electromagnetic radiation source; and providing a second shielding material which is disposed adjacent to the first shielding material for shielding second frequency electromagnetic radiations generated from the at least one electromagnetic radiation source.

In accordance with yet another aspect of the present disclosure, an electromagnetic shielding structure is provided. The electromagnetic shielding structure is for shielding at least a part of electromagnetic radiations generated from at least one electromagnetic radiation source. The electromagnetic shielding structure includes a first shielding material disposed at a first location with respect to the at least one radiation source and a second shielding material attached with the first shielding material in a removable manner. The second shielding material is disposed at a second location with respect to the at least one electromagnetic radiation source so as to define a predetermined gap between the first shielding material and the second shielding material. The first shielding material is configured for shielding at least a part of first frequency electromagnetic radiations generated from the at least one electromagnetic radiation source and penetrating through the second shielding material and the predetermined gap. The second shielding material is configured for shielding at least a part of second frequency electromagnetic radiations generated from the at least one electromagnetic radiation source.

DRAWINGS

These and other features, aspects, and advantages of the present disclosure will become better understood when the following detailed description is read with reference to the accompanying drawings in which like characters represent like parts throughout the drawings, wherein:

FIG. 1 is a schematic block diagram of a system in accordance with an exemplary embodiment of the present disclosure;

FIG. 2 is a perspective view of an electromagnetic shielding structure in accordance with one exemplary embodiment of the present disclosure;

FIG. 3 is a top view of an electromagnetic shielding structure in accordance with another exemplary embodiment of the present disclosure;

FIG. 4 is a graphical illustration of magnetic field intensity inside and outside of a cabinet with different electromagnetic shielding structures employed for shielding low frequency electromagnetic radiations in accordance with one exemplary embodiment of the present disclosure;

FIG. 5 is a graphical illustration of magnetic field intensity inside and outside of a cabinet with different electromagnetic shielding structures employed for shielding first high frequency electromagnetic radiations in accordance with an exemplary embodiment of the present disclosure;

FIG. 6 is a graphical illustration of magnetic field intensity inside and outside of a cabinet with different electromagnetic shielding structures employed for shielding second high frequency electromagnetic radiations in accordance with an exemplary embodiment of the present disclosure;

FIG. 7 is a graphical illustration of total thermal loss generated at the cabinet with different electromagnetic shielding structures employed for shielding low frequency and high frequency electromagnetic radiations in accordance with an exemplary embodiment of the present disclosure; and

FIG. 8 is a flowchart which outlines a method for shielding electromagnetic radiations in accordance with an exemplary embodiment of the present disclosure.

DETAILED DESCRIPTION

Embodiments disclosed herein generally relate to improved electromagnetic shielding structures for power converters (or shortly referred to as converters) for purpose of electromagnetic radiation shielding or suppression. As a general rule, the improved electromagnetic shielding structure provided by the present disclosure can be used in a wide range of applications for shielding electromagnetic radiations generated from one or more electromagnetic radiation sources in association with the converters. For example, the improved electromagnetic shielding structures can be used in association with converters for driving electric machines or AC electric motors at a fixed speed or a variable/adjustable speed. The improved electromagnetic shielding structure can also be used in association with power converters for supplying AC electric power or DC electric power for transmission and distribution. The electromagnetic shielding structures provided by the present disclosure may be combined or integrated with a conventional cabinet to make the cabinet achieve at least dual functions of accommodating the converters therein as well as suppressing or shielding electromagnetic radiations generated from at least one radiation source in association with the operation of the converter. As used herein, the terms "suppress" and "shield" being used interchangeably throughout the description refer to the use of any appropriate material for at least partially absorbing the energy of electromagnetic radiations/waves, or at least partially reflecting the energy of electromagnetic radiations/waves, or at least partially canceling the energy of electromagnetic radiations/waves, or any other mechanism for reducing the intensity or magnitude of the electromagnetic radiations/waves.

In some embodiments, the present disclosure proposes a bi-layer, double-layer, or dual-layer electromagnetic shielding structure that can achieve the function of shielding electromagnetic radiations in a wide radiation frequency spectrum or frequency range. As used herein, "bi-material," "double-material," and "dual-material" electromagnetic shielding structures are not intended to encompass shielding structures only having two shielding materials with the capability of electromagnetic radiation shielding, but rather, are intended to cover shielding structures having at least two shielding materials or multiple shielding materials with the capability of the electromagnetic radiations shielding. In a particular embodiment, the bi-material shielding structure may comprise a first shielding material for example a first shielding metal such as steel for effectively shielding first frequency radiations such as low frequency electromagnetic radiations generated from the at least one radiation source in association with the converter. The bi-material electromagnetic shielding structure may also comprise a second shielding material for example second shielding metal such as copper, aluminum, and/or a combination thereof for effectively shielding second frequency radiations such as high frequency electromagnetic radiations generated from the at least one radiation source in association with the converter.

In some embodiments, the first shielding material and the second shielding material may be mechanically coupled or connected together in a detachable/removable manner by appropriate fastening means. With this detachable/removable configuration, a flexible shielding solution can be selected depending on the frequency of the electromagnetic radiations. For example, the electromagnetic radiations only contain low frequency components, for example, the converter may be commanded to provide low frequency current output to an AC electric motor for low rotation speed operation. In this case, the second shielding material may be removed from the cabinet. In another condition, when the electromagnetic radiations contain high frequency and low frequency components, the second shielding material and the first shielding material can be assembled together at the cabinet. In some embodiments, when the first shielding material and the second shielding material are assembled together, a predetermined gap may be formed between the two shielding materials. In this manner, the second shielding material can be placed nearer to the one or more electromagnetic radiation source for absorbing the high frequency components first.

Still in some embodiments, in addition to using the proposed bi-material electromagnetic shielding structure to suppress electromagnetic radiation in a manner to prevent electromagnetic radiations transmitted in an inside-to-outside direction, the bi-material electromagnetic shielding structure proposed herein can also be applied to shield electromagnetic radiations in a manner to prevent electromagnetic radiations transmitted in an outside-to-inside direction. For example, the bi-material electromagnetic shielding structure may be combined with or integrated with a protective cover/casing for an electrical component such as a processor and a controller, such that electromagnetic interference with one or more electrical or electronic components located inside of the cabinet can be prevented. Consequently, device failures of the processor and controller caused by the electromagnetic interferences can be avoided.

With the proposed electromagnetic shielding structure disclosed herein, the present disclosure can achieve a plurality of technical effects or benefits, one of which is electromagnetic radiations in a wide frequency spectrum or frequency range generated in association with the operation of the converter can be suppressed, such that the system can pass the safety standard in relation to electromagnetic radiations. Another technical effect or benefit is that by employing the proposed bi-layer shielding structure, at least one side of the cabinet for accommodating the converter therein can be maintained at a low temperature for preventing thermal damage to an operator even the radiation source contains high frequency components and/or high current. Other technical effects or benefits will be apparent to those skilled in the art by referring to the detailed descriptions provided below and the accompanying the drawings.

Unless defined otherwise, technical and scientific terms used herein have the same meaning as is commonly understood by one of ordinary skill in the art to which this disclosure belongs. The terms "first," "second," and the like, as used herein do not denote any order, quantity, or importance, but rather are used to distinguish one element from another. Also, the terms "a" and "an" do not denote a limitation of quantity, but rather denote the presence of at least one of the referenced items. The term "or" is meant to be inclusive and mean any, several, or all of the listed items. The use of "including," "comprising," "having" and variations thereof herein are meant to encompass the items listed thereafter and equivalents thereof as well as additional items. The terms "connected" and "coupled" are not restricted to physical or mechanical connections or couplings, and can include electrical connections or couplings, whether in a direct or indirect manner. Furthermore, the terms "circuit," "circuitry," and "controller" may include either a single component or a plurality of components, which are either active and/or passive and may be optionally be connected or otherwise coupled together to provide the described function.

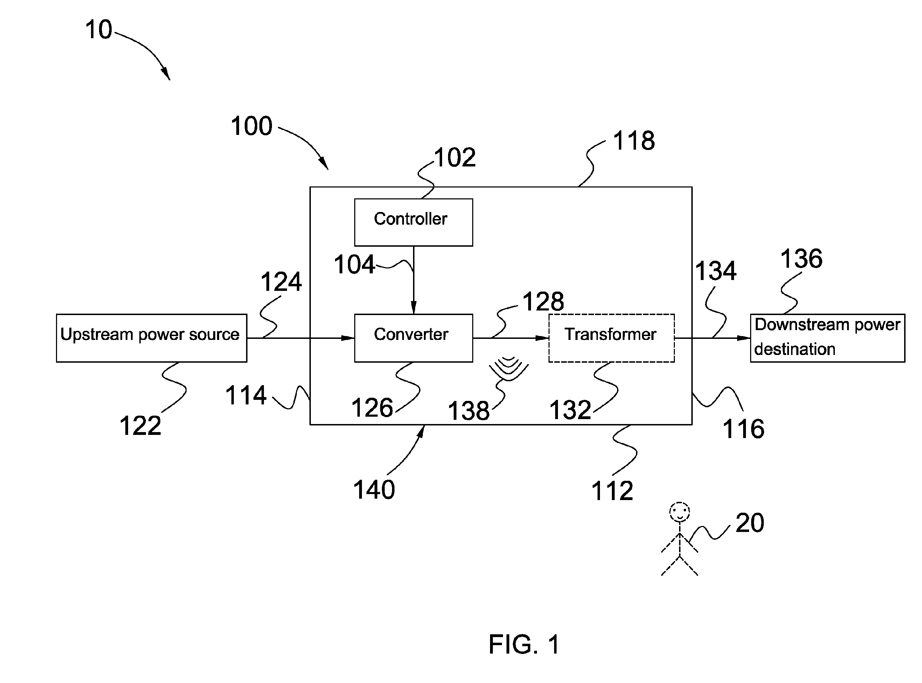

FIG. 1 illustrates a block diagram of a system 10 in accordance with an exemplary embodiment of the present disclosure. The system 10 may be any appropriate converter based system capable of being configured to perform power conversion in a wide range of applications such as a vehicle, a pump, a wind turbine generator, a solar panel, a fan, a compressor, a mixer, a mill, a conveyor, and so on. In one non-limiting example, the system 10 can be a medium voltage drive system which is configured to drive one or more AC electric motors operating at a fixed speed or a variable speed.

As illustrated in FIG. 1, the system 10 includes a converter 126 which is capable of being housed or accommodated in a cabinet or enclosure 100. In general, the converter 126 is configured to convert a first electric power 124 provided from an upstream power source 122 to a second electric power 128 for a downstream power destination 136. Each of the first electric power 124 and the second electric power 128 can be DC power and AC power. As used herein, "DC" refers to an electric parameter that has a constant value/level or an electric parameter formed by superimposing noise signals or ripples with a constant value/level. As used herein, "AC" refers to an electric parameter varying as a function of time in a periodic manner and may contain fundamental components as well as harmonic components. In one embodiment, the converter 126 may comprise a DC-to-AC converter such as a multi-level inverter for converting first electric power 124 having a DC form to second electric power 128 having an AC form. In another embodiment, the converter 126 may comprise a DC-to-DC converter such as a single-active-bridge converter and a dual-active-bridge converter for converting first electric power 124 having a DC form to second electric power 128 also having a DC form. Still in another embodiment, the converter 126 may comprise an AC-to-DC converter such as a multi-level rectifier for converting first electric power 124 having an AC form to second electric power 128 having a DC form. Yet in another embodiment, the converter 126 may comprise an AC-to-AC converter such as a matrix converter for converting first electric power 124 having an AC form to second electric power 128 also having an AC form. In one embodiment, the upstream power source 122 may be at least part of a power grid for supplying AC electric power or DC power to the converter 126. The upstream power source 122 may also be a power generation device such as a wind turbine or a solar panel for supplying AC power or DC power to the converter 126. In one embodiment, the second electric power 128 may be directly supplied to a downstream power destination 136 which may be a power grid for power transmission and distribution. In another embodiment, the second electric power 128 may be transformed by a transformer to have a voltage matched with the downstream power destination 136 such as power grid. In some embodiments, the downstream power destination 136 may be a load such as an AC electric motor which is capable of being driven by the second electric power 128.

With continuing reference to FIG. 1, the converter 126 may be in communication with a controller 102 for receiving one or more control signals 104 from the controller 102. In response to the control signals 104, the converter 126 can be controlled to provide an output having desired parameters such as voltage, current, frequency, and phase. The controller 40 may include any suitable programmable circuits or devices such as a digital signal processor (DSP), a field programmable gate array (FPGA), a programmable logic controller (PLC), and an application specific integrated circuit (ASIC). The converter 126 may include a plurality of switching elements/devices such as IGBT and IGCT (not shown) arranged in a predetermined topology, including but not limited to, a diode clamped topology, a flying capacitor clamped topology, and an H-bridge topology. The plurality of switching elements/devices can be switched on and off according to the control signals 104 such as pulse signals and/or gating signals provided from the controller 102 in a predefined pattern or sequence.

Further referring to FIG. 1, during normal operation, the system 10 typically will emit electromagnetic radiations from one or more electromagnetic radiation sources in association with the converter 126 due to the switching operations of the plurality switching elements/devices in the converter 126. As shown in FIG. 1, in one embodiment, one or more conduction paths coupled between the converter 126 and the downstream power destination 136 for transporting the second electric power 128 may become one or more electromagnetic radiation sources. In one embodiment, bus-bars used as the conduction path are capable of emitting one or more electromagnetic radiations when alternating current as well as harmonic components contained in the second electric power 128 are transmitted through the one or more conduction paths. In some embodiments, the electromagnetic radiations can be very strong when the converter 126 is commanded to provide the alternating current with a high frequency and/or a high current. For example, the alternating current provided from the converter 126 may be several hundred Hertz and several thousand Amperes when an AC electric motor is desired to operate at a high rotation speed. As a non-limiting example, the converter 126 may be instructed to provide an alternating current output having a frequency of about 467 Hz and current amplitude of about 1000 A. In one embodiment, to prevent the electromagnetic radiations generated from the one or more electromagnetic radiation sources from being transmitted to the outside of the cabinet 100 to satisfy at least some electromagnetic emission requirements, at least one side of the cabinet 100 may be provided with an electromagnetic shielding structure for shielding the electromagnetic radiations.

Further referring to FIG. 1, in one embodiment, the cabinet 100 at least includes a front side 112, a left side 114, a right side 116, and a back side 118 that are sequentially connected to form a structure for accommodating the converter 126 therein. As shown in FIG. 1, the cabinet 100 may also be configured to accommodate one or more other components, such as the controller 102 and transformer 132 therein. In one embodiment, all of the four cabinet sides 112, 114, 116, 118 may be provided with a respective electromagnetic shielding structure for shielding electromagnetic radiations generated within the cabinet 110. In another embodiment, a single-piece shielding structure may be attached to the four cabinet sides 112, 114, 116, 118 for shielding the electromagnetic radiations. In some embodiments, one or more electromagnetic shielding structures may be particularly disposed on a cabinet side that is located closer with respect to the one or more electromagnetic radiation sources. That is to say, for the cabinet side that is located farther away from the one or more electromagnetic radiation source, in some occasions, it may be not necessary to the provide the electromagnetic shielding structures thereon, because the electromagnetic radiations arriving at the cabinet side may be attenuated to an acceptable level. The electromagnetic radiations emitted from the electromagnetic radiation source can be expressed by the following equations:

$$\dot{E}_x(z) = \dot{E}_x(0) \cdot e^{-\frac{z}{\delta}} \cdot e^{-j\frac{z}{\delta}} \quad (1), \quad \dot{H}_y(z) = \dot{H}_y(0) \cdot e^{-\frac{z}{\delta}} \cdot e^{-j\frac{z}{\delta}} \quad (2),$$ where $\dot{E}_x(0)$ is the magnitude of the electric field generated at the radiation source, $\dot{H}_y(0)$ is the magnitude of the magnetic field generated at the radiation source, z is certain position in the space that the electric field or the magnetic field may arrive at, $\delta$ is the skin depth. According to equation (2), the magnitude of the magnetic field at a distance $t_d$ can be expressed by the following equation:

$$\left|\dot{H}_y(z = t_d)\right| = \left|\dot{H}_y(z = 0)\right| \cdot e^{-\frac{t_d}{\delta}} \quad (3).$$ It can be seen from equation (3) that when the distance is larger than $3\delta$, the magnetic radiation can be substantially attenuated to zero.

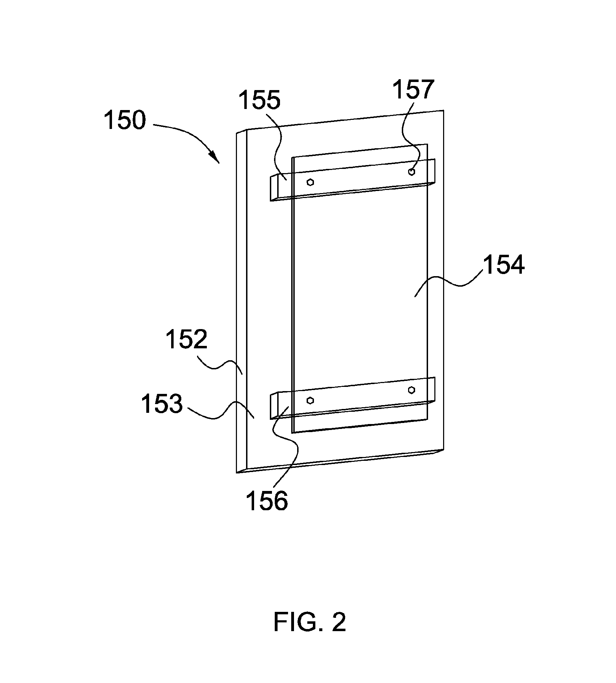

In one embodiment, as shown in FIG. 1, an electromagnetic shielding structure 140 may be particularly provided at the front side 112 of the cabinet 100. In some embodiments, the front side 112 may be arranged with a door structure that can be opened or closed to allow an operator 20 to access one or more components such as the converter 126 located inside of the cabinet 100. As will be described in more detail below, providing the electromagnetic shielding structure 140 at the front side 112 of the cabinet 100 is advantageous not only because electromagnetic radiations can be effectively suppressed by the electromagnetic shielding structure 140, but also the front side 112 can be maintained at a low temperature. As a result, when the operator 20 is instructed to perform maintenance operations with respect to one or more components located inside of the cabinet 100, potential thermal damages to the operator 20 can be avoided. One example of the electromagnetic shielding structure will be described with reference to FIG. 2.

Referring to FIG. 2, a perspective view of an electromagnetic shielding structure 150 in accordance with one exemplary embodiment of the present disclosure is illustrated. The electromagnetic shielding structure 150 may be used as the electromagnetic shielding structure 140 shown in FIG. 1. In one embodiment, the electromagnetic shielding structure 150 is constructed to have a bi-layer, double-layer, or dual-layer electromagnetic shielding structure. For example, in one embodiment, the electromagnetic shielding structure 150 may include at least a first shielding member 152. In one embodiment, the first shielding member 152 can be integrally formed as part of the front side 112 (shown in FIG. 1) for at least accommodating the converter 126 therein. In other embodiments, the first shielding member 152 can be separately formed and be attached to the front side 112 of the cabinet 100 by one or more fastening means. In the illustrated embodiment, the first shielding member 152 is arranged to have a generally flat plate structure having a predetermined thickness. In some embodiments, the first shielding member 152 can be constructed to have other structures. For example, the first shielding member 152 can be defined with a plurality of through holes/openings having any appropriate shapes, such as circular, elliptical, square, rectangular, and polygonal, to form a mesh structure. A mesh structure can allow heat generated at the first shielding member 152 or the front side 112 of the cabinet 100 to be more easily dissipated to the environment while the normal electromagnetic shielding function performed by the first shielding member 152 can still be retained. In one embodiment, the first shielding member 152 may be made from a first type of metal shielding material, such as steel for effectively shielding or suppressing first electromagnetic radiations having a frequency located in a first frequency spectrum or frequency range. In one embodiment, the first frequency spectrum may range from about 0 Hz to about 100 Hz. In other embodiments, any appropriate material either commercially available in the market or developed in the future that has similar shielding characteristics such as skin depth, conductivity, and/or permeability as steel capable of shielding electromagnetic radiations in a low frequency range can be used in the present disclosure.

With continuing reference to FIG. 2, in one embodiment, the bi-layer electromagnetic shielding structure 150 further include a second shielding member 154. In one embodiment, the second shielding member 154 is similarly arranged to have a generally flat plate structure having a predetermined thickness. The second shielding member 154 is shaped to have a smaller overall size than the first shielding member 154 for purpose of being assembled with the first shielding member 154. In other embodiment, similar to the first shielding member 152, the second shielding member 154 can also be constructed to have other structures. For example, the second shielding member 154 can also be defined with a plurality of holes/opening having any appropriate shapes, such as circular, elliptical, square, rectangular, and polygonal to form a mesh structure for facilitating thermal dissipation without substantially sacrificing the electromagnetic radiation shielding function. In one embodiment, the second shielding member 154 may be made from a second type of metal shielding material, such as copper or aluminum for effectively shielding second electromagnetic radiations having frequency value located in a second frequency spectrum or frequency range. In a particular embodiment, the second frequency range may be from about 100 Hz to about 1000 Hz. In other embodiments, any appropriate material either commercially available in the market or developed in the future that has similar characteristics such as skin depth, conductivity, and permeability as copper and aluminum can be used in the present disclosure. Still in some embodiments, the second shielding member 154 may be made from a combination of the copper, aluminum, and any other appropriate material.

With continuing reference to FIG. 2, in one embodiment, the first shielding member 152 is coupled to the second shielding member 154 in a detachable or removable manner. The detachable or removable configuration has the benefit of allowing the second shielding member 154 to be removed from the first shielding member 154. In some embodiments, the second shielding member 154 may be replaced with a new one or with different physical configurations such as size, shape, and thickness. More specifically, in one embodiment, one side or an inner side 153 of the first shielding member 152 is provided with at least one coupling member for coupling the second shielding member 154 with the first shielding member 152. In one embodiment, two coupling members 155, 156 are provided at the inner side of the first shielding member 152 for firmly securing the second shielding member 154 thereto. The first coupling member 155 is disposed adjacent to an upper end of the first shielding member 152 and the second coupling member 156 is disposed adjacent to a lower end of the first shielding member 152. The first and second coupling members 155, 156 may be defined with one or more openings or holes such that one or more screws 157 can be used to secure the second shielding member 154 and the first shielding member 152 together. In alternative embodiment, the first shielding member 152 and the second shielding member 154 can be firmly secured together by other means, such as wielding.

With continuing reference to FIG. 2, in one embodiment, the first and second coupling members 155, 156 placed at the inner side of the first shielding member 152 is particularly designed to have a predetermined height. Thus, when the second shielding member 154 is secured to the first shielding member 152 via the first and second coupling members 155, 156, a gap or an intermediate layer is defined between the first shielding member 152 and the second shielding member 154. In one embodiment, as shown in FIG. 2, the gap or the intermediate layer is filled with atmosphere therein. In other embodiments, the gap or the intermediate layer may be filled with other insulated materials. Due to this gap or intermediate layer, when the electromagnetic shielding structure 150 is provided at the front side 112 of the cabinet 100, the second shielding member 154 is positioned nearer to the one or more electromagnetic radiation source than the first shielding member 152. With this configuration, when one or more electromagnetic radiations are emitting from the one or more electromagnetic radiation sources in association with the converter 26, the second shielding member 154 will receive the electromagnetic radiations first, such that high frequency electromagnetic radiations will be shielded first by the second shielding member 154.

As is known, a skin depth of a material for purpose of electromagnetic radiation shielding can be expressed by the following equation: $\delta = \sqrt{\dfrac{2}{2\pi f \sigma \mu_0 \mu_r}}$ $(4)$, where $\delta$ is the skin depth, f is the frequency of the electromagnetic radiations, $\sigma$ is the conductivity of the shielding material, $\mu_0$ is the permeability of free space, $\mu_r$ is the relative permeability of the shielding material. According to equation (4), since the copper and aluminum has a smaller relative permeability than the steel, the skin depth of the second shielding member 154 which is made from copper or aluminum is larger than that made from steel. Comparing to using steel material for shielding the high frequency electromagnetic radiations, using the copper and aluminum material can significantly reduce thermal loss due to a larger skin depth of the copper and aluminum. Consequently, the front side of the cabinet 100 can be maintained at a relatively low temperature. Table-1 shows typical skin depth data of copper, aluminum, and steel at different electromagnetic radiation frequencies. For electromagnetic radiations having high frequency components, the copper and aluminum has larger skin depth than the steel. For example, at a first high frequency of 467 Hz, the skin depth of the aluminum and copper are 3.97 and 3.06 respectively, which are both larger than steel having a skin depth of 0.42. Increasing the frequency can reduce the skin depth. For example, at a second high frequency value of 567 Hz, the skin depth of the aluminum and copper are reduced to 3.60 and 2.78 respectively, which are still larger than steel material having a skin depth of 0.38.

Table-1 Skin Depth of Aluminum, Copper, and Steel

| Frequency/$f$ (Hz) | Skin Depth/$\delta$ (mm) | | |
|---|---|---|---|
| | Aluminum | Copper | Steel |
| 50 | 12.12 | 9.35 | 1.29 |
| 467 | 3.97 | 3.06 | 0.42 |
| 567 | 3.60 | 2.78 | 0.38 |

Further referring to FIG. 2, the second shielding member 154 can be particularly designed with a predetermined thickness to allow high frequency components to be shielded or suppressed and let low frequency components to pass through. More specifically, the low frequency components contained in the electromagnetic radiations penetrating through the second shielding member 154 will further propagate through the gap defined between the first shielding member 152 and the second shielding member 154 and arrive at the first shielding member 152. The low frequency electromagnetic radiations are further shielded or suppressed by the first shielding member 152 made of steel. As shown in table-1 above, at low frequency, for example at 50 Hz, the steel shielding material has a thin skin depth of 1.29. The thin skin depth still can allow the low frequency electromagnetic radiations absorbed by the first shielding member 152 while the thermal loss generated at the first shielding member 152 is low.

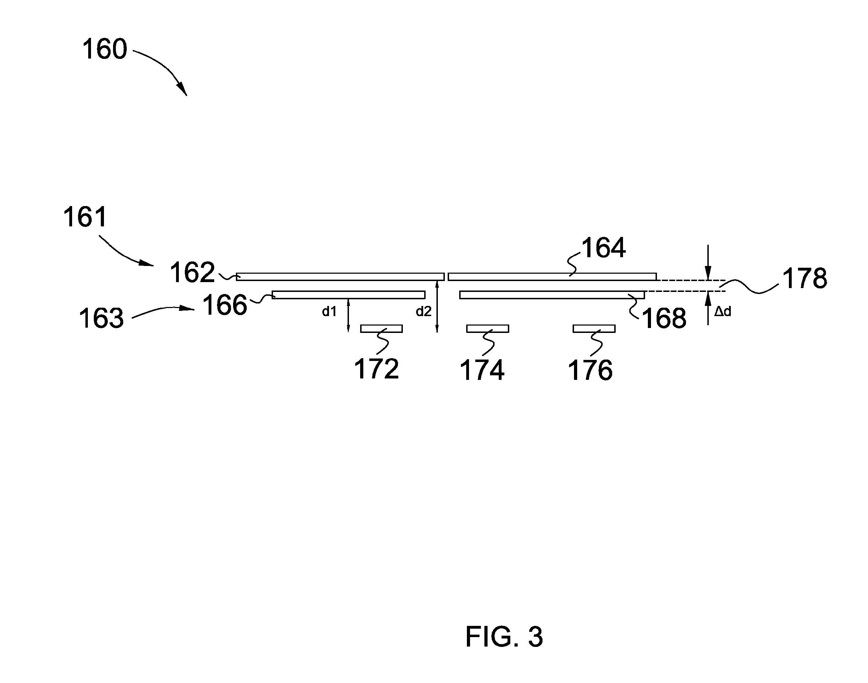

FIG. 3 illustrates a top view of an electromagnetic shielding structure 160 in accordance with another embodiment of the present disclosure. The electromagnetic shielding structure 160 shown in FIG. 3 can be used as the electromagnetic shielding structure 140 shown in FIG. 1. More particularly, the electromagnetic shielding structure 160 is suitable for being attached to one side for example the front side 112 of the cabinet 100 which has a double door structure. In the illustrated embodiment, the electromagnetic shielding structure 160 is similarly arranged to have a dual-layer shielding structure. For example, the electromagnetic shielding structure 160 may include a first shielding layer 161 and a second shielding layer 163. Different than the electromagnetic shielding structure 150 shown in FIG. 2, the first shielding layer 161 includes a pair of first shielding members 162, 164. Each of the pair of first shielding members 162, 164 may be integrally formed as part of a respective door portion of the front side 112 of the cabinet 100. In other embodiments, each of the pair of first shielding members 162, 164 may be detachably/removably attached to the respective door portion of the front side 112 of the cabinet 100. In one embodiment, the pair of first shielding members 162, 164 may be made from a first type of metal shielding material, such as steel for effectively shielding first electromagnetic radiations having a frequency located in a first frequency spectrum or frequency range. In other embodiments, any appropriate material either commercially available in the market or developed in the future that has similar shielding characteristics such as skin depth, conductivity, and permeability as steel capable of shielding electromagnetic radiations in a low frequency range can be used in the present disclosure. Still in some embodiments, the first shielding layer 161 may comprise more than two shielding members.

With continuing reference to FIG. 3, in one embodiment, the second shielding layer 163 includes a pair of second shielding members 166, 168. In one embodiment, the pair of second shielding members 166, 168 may be made from a second type of metal shielding material, such as copper and aluminum for effectively shielding second electromagnetic radiations having frequency value located in a second frequency spectrum or frequency range. In other embodiments, any appropriate material either commercially available in the market or developed in the future that has similar characteristics such as skin depth, conductivity, and permeability as copper and aluminum can be used in the present disclosure. Still in some embodiments, more than two metal materials having high conductivity and low permeability such as copper and aluminum can be combined to form the second shielding members 166, 168.

With continuing reference to FIG. 3, in some embodiments, the electromagnetic shielding structure 160 may be configured to shield electromagnetic radiations generated from at least first, second, and third electromagnetic radiation source 172, 174, 176. In the illustrated embodiment, the three electromagnetic radiation sources 172, 174, 176 are configured for transmitting converter outputs provided from the converter 126 to the load such as a three-phase AC electric motor. More specifically, the first electromagnetic radiations source 172 may be a first bus-bar conduction path for transmitting first phase current provided from the converter 126 to a first winding of the AC electric motor. The second electromagnetic radiation source 174 may be a second bus-bar conduction path for transmitting a second phase current provided from the converter 126 to a second winding of the AC electric motor. The third electromagnetic radiation source 176 may be a third bus-bar conduction path for transmitting third phase current provided from the converter 126 to a third winding of the AC electric motor.

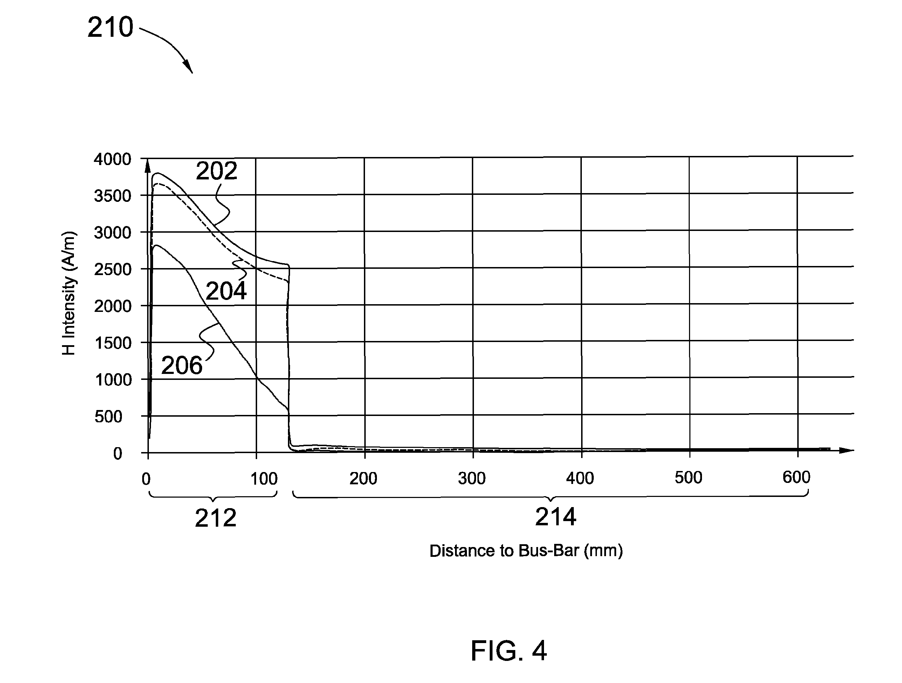

As can be seen in FIG. 3, the first shielding layer 161 or the pair of first shielding members 162, 165 are positioned at a first distance d1 relative to the three radiations sources 172, 174, 176. The second shielding layer 163 or the pair of second shielding members 166, 168 are positioned at a second distance d2 which is smaller than the first distance d1 relative to the three radiation sources 172, 174, 176. Thus, a gap or intermediate layer 178 is defined between the first shielding layer 161 and the second shielding layer 163. In one embodiment, the gap or intermediate layer 178 is filled with atmosphere. In other embodiments, the gap or intermediate layer 178 may be filled with other materials such as insulated material therein. With this configuration, when the three radiation sources 172, 174, 176 emit radiations inside of the cabinet, the pair of second shielding members 166, 168 will function to the shield or suppress high frequency component contained in the electromagnetic radiations. The low frequency part of the electromagnetic radiations penetrating through the pair of second shielding members 166, 168 and the gap 178 will be suppressed or shielded by the pair of first shielding members 162, 164. Thus, by providing the electromagnetic shielding structure 160 on at least one cabinet side of the cabinet 100, a wide frequency range electromagnetic radiations generated from one or more electromagnetic radiations sources within the cabinet can be well suppressed or shielded. The electromagnetic shielding effect can be better seen by referring to a couple of diagrams shown in FIGS. 4-6.

FIG. 4 illustrates low frequency electromagnetic radiation shielding result 210 of a conventional solution using steel shielding material and proposed solutions of using bi-layer shielding materials. More specifically, FIG. 4 illustrates a magnetic field intensity of the electromagnetic radiations as a function of distance at a frequency of 50 Hz. In the illustrated diagram, a first curve 202 represents the magnetic intensity of the electromagnetic radiations as a function of distance in which a combination of steel and copper are used for shielding the electromagnetic radiations. A second curve 204 represents the magnetic intensity of the electromagnetic radiations as a function of distance in which a combination of steel and aluminum are used for shielding the electromagnetic radiations. A third curve 206 represents the magnetic intensity of the electromagnetic radiations as a function of distance in which steel material is used for shielding the electromagnetic radiations. As shown in these curves 202, 204, 206, in a first range 212, starting from a first position where the electromagnetic radiation source for example a bus-bar is located to a second position where the shielding material is located, the steel and copper combination shielding structure and the steel and aluminum combination shielding structure can cause less magnetic attenuation than the steel shielding structure. Further as shown in FIG. 4, in a second range 214, starting from the second position where the shielding material is located to an outside of the cabinet, using the steel and copper combination shielding structure and the steel and aluminum combination shielding structure can cause the magnetic intensity substantially reduced to zero, which is better than the steel shielding structure.

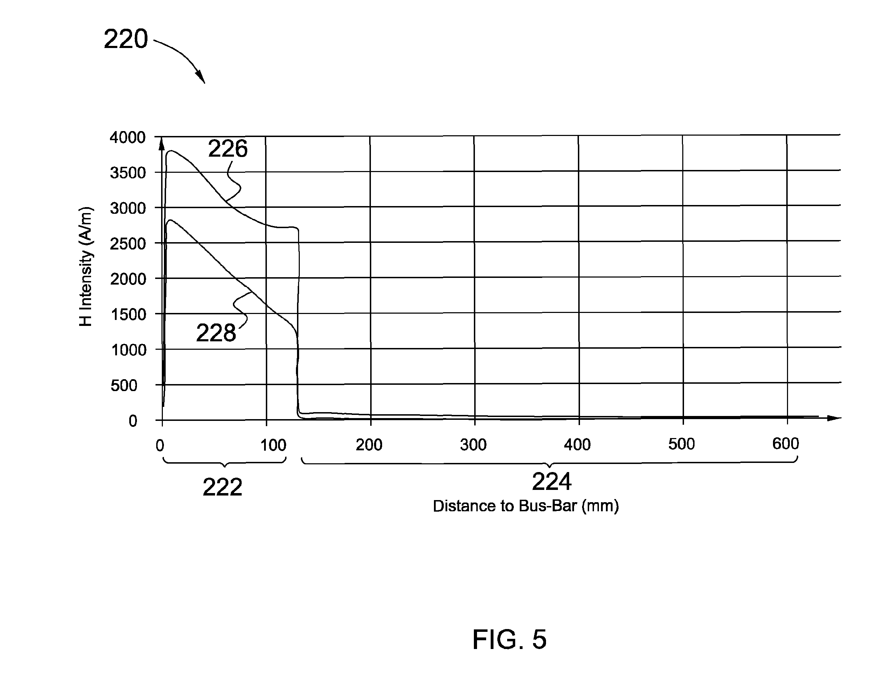

FIG. 5 illustrates high frequency electromagnetic radiations shielding result 220 using the electromagnetic shielding structure 160 shown in FIG. 3 in accordance with an exemplary embodiment of the present disclosure. More specifically, the electromagnetic shielding structure 160 is used for shielding the electromagnetic radiations at a frequency of 467 Hz. As shown in FIG. 5, first curve 226 represents the magnetic intensity of the electromagnetic radiations as a function of distance in which steel and copper combined shielding structure is used for shielding the electromagnetic radiations. Further as shown in FIG. 5, a second curve 228 represents the magnetic intensity of the electromagnetic radiations as a function of distance in which steel shielding material is used for shielding the electromagnetic radiations. It can be seen that, in a first range 222, starting from a first position where the electromagnetic radiation source is located to a second position where the shielding structure is positioned, the steel and copper combined shielding structure causes the magnetic intensity to have less magnetic attenuations than the steel shielding structure. Further as shown in FIG. 5, in a second range 224, starting from the second position where the shielding structure is positioned to the outside of the cabinet, the magnetic intensity is substantially reduced to zero. Thus, in some aspects, using the newly proposed shielding structure of a combination of copper and steel can have comparable shielding effect as the conventional shielding structure using steel material for shielding for example.

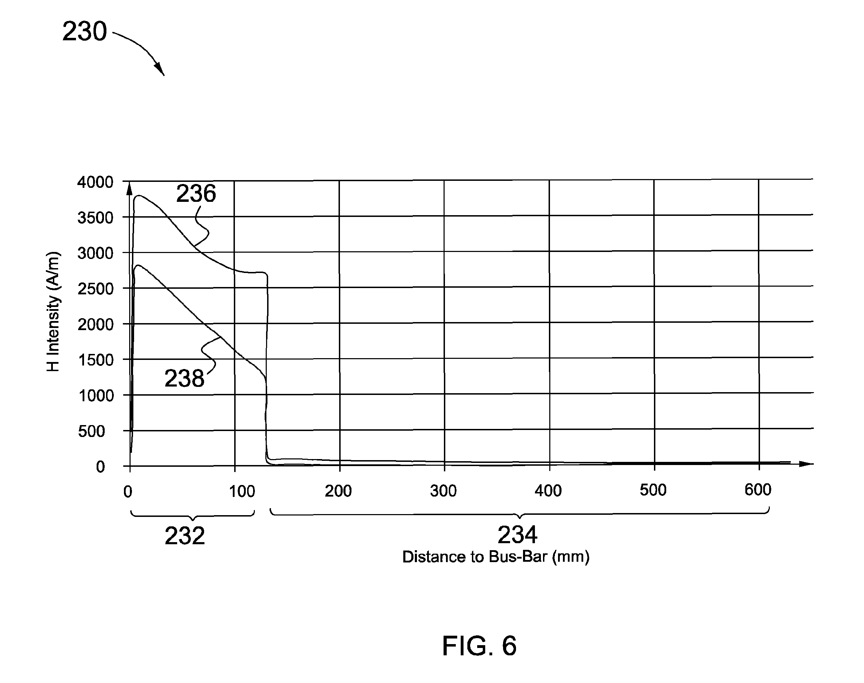

FIG. 6 illustrates high frequency electromagnetic radiations shielding result 230 using the electromagnetic shielding structure 160 shown in FIG. 3 in accordance with another exemplary embodiment of the present disclosure. More specifically, the electromagnetic shielding structure 160 is used for shielding the electromagnetic radiations at frequency of 567 Hz. Similar to FIG. 5, in a first range 222, the steel and copper combined shielding structure can also cause the magnetic intensity to have less magnetic attenuations than the steel shielding structure. Further as shown in FIG. 6, in a second range 234, the magnetic intensity is substantially reduced to zero. Thus, in some aspects, using the newly proposed shielding structure at least a combination of copper and steel can have comparable shielding effect as the conventional shielding structure using steel material for shielding for example.

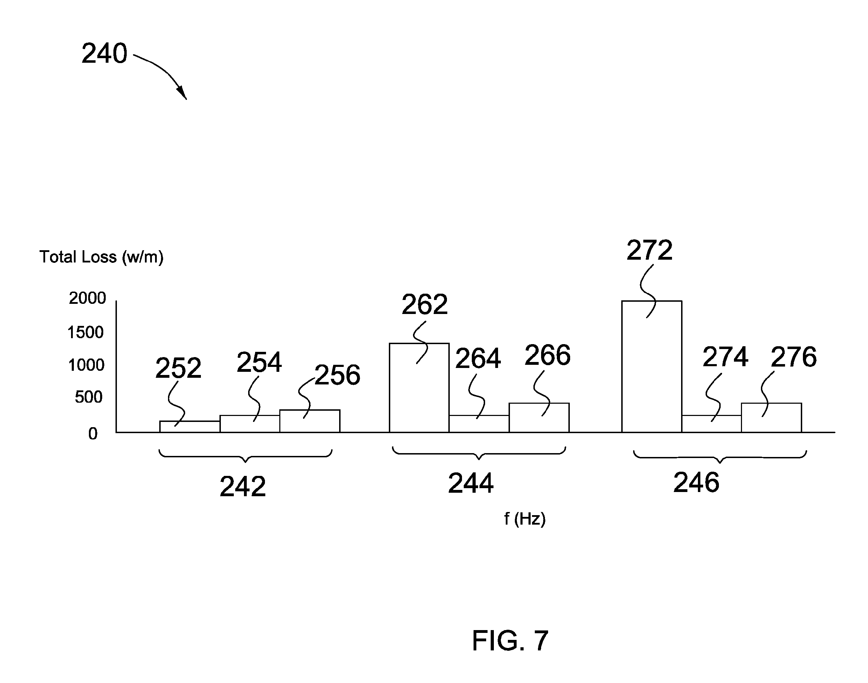

FIG. 7 illustrates the total thermal loss 240 generated at the shielding structure for shielding electromagnetic radiations having different frequencies in accordance with an exemplary embodiment of the present disclosure. Referring to FIG. 7, a first group 242 shows the total thermal loss generated by using the conventional shielding structure and the newly proposed shielding structure for shielding electromagnetic radiations having a low frequency of 50 Hz. As shown in the bars, for shielding electromagnetic radiations having low frequency value, using the newly proposed shielding structures (the steel plus copper and steel plus aluminum, shown in 254, 256) generate substantially small thermal loss as the conventional electromagnetic shielding structure (the steel shielding structure, shown in 252).

Further referring to FIG. 7, a second group 244 and a third group 246 shows the generated total thermal loss for shielding a first high frequency electromagnetic radiations of 467 Hz and a second high frequency electromagnetic radiations of 567 Hz. As shown in bars, using the newly proposed electromagnetic shielding structures (steel plus copper and steel plus aluminum, shown in 264, 266, 274, 276) can generate much less thermal loss than by using the conventional electromagnetic shielding structure (the steel shielding structure, shown in 262, 272).

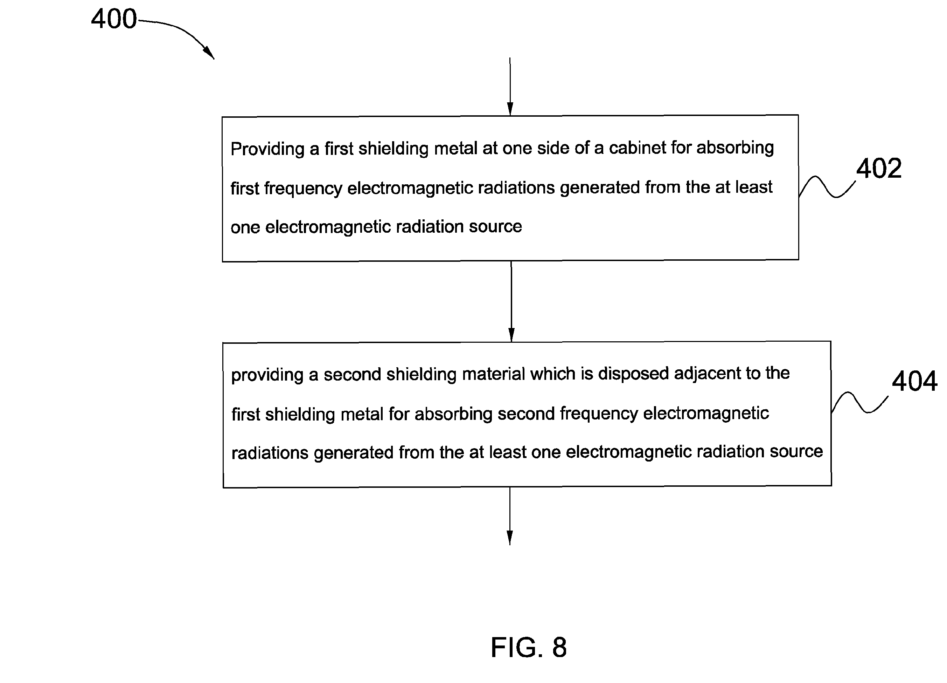

FIG. 8 illustrates a flowchart of a method 400 of using electromagnetic shielding structures for shielding or suppressing electromagnetic radiations generated within a cabinet in accordance with an exemplary embodiment. In some embodiments, the method 400 can also be implemented for maintaining at least one side of a cabinet at low temperature.

In one implementation, the method 400 may start to implement from block 402. At block 402, a first shielding member may be provided for purpose of shielding or suppressing low frequency electromagnetic radiations. In one embodiment, the first shielding member may be provided on at least one side of a cabinet for example the cabinet 100 shown in FIG. 1. In one embodiment, the first shielding member may comprise steel material or any other material having similar characteristics as steel particularly designed for shielding electromagnetic radiations having low frequency components. In some embodiments, the first shielding material may integrally formed as part of a side of the cabinet for accommodating one or more components such as a converter therein. In another embodiment, the first shielding material may be detachably or removably attached to one side of the cabinet. In some embodiments, the first shielding material is particularly being provided at the side of the cabinet that is located nearer to the one or more electromagnetic radiations sources.

At block 404, a second shielding member is provided for purpose of shielding or suppressing high frequency electromagnetic radiations. In one embodiment, the second shielding member may comprise copper and aluminum material or any other material that has similar characteristics as copper and aluminum for shielding or suppressing electromagnetic radiations having high frequency components. In some embodiments, the second shielding material may be coupled to the first shielding member in a detachable or removable manner. More specifically, in some embodiments, a predetermined gap or an intermediate layer may be defined between the first shielding member and the second shielding member, such that the second shielding member can be placed closer to the one or more electromagnetic radiations sources than the first shielding member. Thus, high frequency electromagnetic radiations generated from the one or more electromagnetic sources can be first suppressed by the second shielding member. Because high conductivity and low permeability material are used by the second shielding member for shielding or suppressing the high frequency electromagnetic radiations, less thermal loss are generated at the cabinet side that is attached with the shielding structure, and as a result the cabinet can be maintained at a low temperature.

The method 400 described with reference to FIG. 10 may be modified in various ways in accordance with certain embodiments of the present disclosure. For example, the operations performed at blocks 402 and 404 can exchange order in some embodiments. In some embodiments, the second shielding member can be provided prior to providing the first shielding member. In other embodiment, the method 404 may comprise additional operations. In some implementation, after block, the method 400 may further include a block for securing the first shielding member and the second shielding member together. For example, the first shielding member and the second shielding member may be secured together by screws.

While the invention has been described with reference to exemplary embodiments, it will be understood by those skilled in the art that various changes may be made and equivalents may be substituted for elements thereof without departing from the scope of the invention. Furthermore, the skilled artisan will recognize the interchangeability of various features from different embodiments. Similarly, the various method steps and features described, as well as other known equivalents for each such methods and feature, can be mixed and matched by one of ordinary skill in this art to construct additional assemblies and techniques in accordance with principles of this disclosure. In addition, many modifications may be made to adapt a particular situation or material to the teachings of the invention without departing from the essential scope thereof. Therefore, it is intended that the invention not be limited to the particular embodiment disclosed as the best mode contemplated for carrying out this invention, but that the invention will include all embodiments falling within the scope of the appended claims.

## Claims

1. A system (10) for driving an AC electric motor, the system comprising:

   a converter (126) capable of being operated to perform power conversion and provide at least a first phase AC current output to a first winding of the AC electric motor via a first conduction path, a second phase AC current output to a second winding of the AC electric motor via a second conduction path, and a third phase AC current output to a third winding of the AC electric motor via a third conduction path; and
   a cabinet (100) for accommodating the converter (126) therein, the cabinet (100) comprising:

      a first shielding member (152; 162, 164), for example comprising steel material, the first shielding member (152; 162, 164) being disposed on at least one side of the cabinet (100), the first shielding member (152; 162, 164) capable of absorbing at least a part of first frequency range electromagnetic radiations generated from at least one of the first phase AC current flowing through the first conduction path, the second phase AC current flowing through the second conduction path, and the third phase AC current flowing through the third conduction path; and
      a second shielding member (154; 166, 168), for example comprising copper or aluminum material, the second shielding member (154; 166, 168) being disposed adjacent to the first shielding member (152; 162, 164), the second shielding member (154; 166, 168) capable of absorbing at least a part of second frequency range electromagnetic radiations generated from at least one of the first phase AC current flowing through the first conduction path, the second phase AC current flowing through the second conduction path, and the third phase AC current flowing through the third conduction path.

2. The system of claim 1, wherein the first shielding member (152; 162, 164) is configured for absorbing the first frequency electromagnetic radiations having a frequency value corresponding to a low rotation speed of the AC electric motor.

3. The system of claim 1 or claim 2, wherein the second shielding member (154; 166, 168) is configured for absorbing the second frequency electromagnetic radiations having a frequency value corresponding to a high rotation speed of the AC electric motor.

4. The system of any preceding claim, wherein the first shielding member (152; 163, 164) is disposed on a front side (112) of the cabinet (100), and the front side (112) of the cabinet (100) is capable of being opened by an operator to perform maintenance operations for the converter (126) located inside of the cabinet (100).

5. The system of any preceding claim, wherein the second shielding member (154; 166, 168) is disposed in a manner closer to any one of the first, second, and third conduction paths than the first shielding member (152; 162, 164), and the second shielding member (154; 166, 168) is invisible when a front side (112) of the cabinet (100) is closed.

6. The system of any preceding claim, wherein the first shielding member (152) and second shielding member (154) are substantially spaced apart by a predetermined gap with atmosphere filled between the gap, and the first shielding member (152) and the second shielding member (154) are secured together by fastening means (155-157).

7. A method for shielding electromagnetic radiations generated from at least one electromagnetic radiation source (172-176) in association with a converter (126) accommodated within a cabinet (100), the method comprising:

providing a first shielding material (152; 162, 164), for example a first shielding metal made from steel material, the first shielding material (152; 162, 164) being at one side of the cabinet (100) for shielding first frequency range electromagnetic radiations generated from the at least one electromagnetic radiation source (172-176); and
providing a second shielding material (154; 166, 168) which is disposed adjacent to the first shielding metal (152; 162, 164) for shielding second frequency range electromagnetic radiations generated from the at least one electromagnetic radiation source (172-176).

8. The method of claim 7, wherein the step of providing a second shielding material (154; 166, 168) comprises providing the second shielding material (154; 166, 168) which is located closer to the at least one electromagnetic radiation source (172-176) than the first shielding material (152; 162, 164).

9. The method of claim 7 or claim 8, wherein the step of providing a first shielding material (152; 162, 164) comprises providing a first shielding metal which has a smaller skin depth than that of the second shielding material (154; 166, 168) for absorbing at least a part of the first frequency electromagnetic radiations penetrating through the second shielding material (154; 166, 168).

10. The method of any of claims 7 to 9, wherein the step of providing a second shielding material (154; 166, 168) comprises providing a second shielding metal made from high conductivity and low permeability material.

11. The method of any of claims 7 to 10, wherein the step of providing a second shielding material (154; 166, 168) comprises disposing the second shielding material (154; 166, 168) on an inner side of the first shielding material (152; 162, 164).

12. The method of any of claims 7 to 11, wherein the step of providing a first shielding material (152; 162, 164) comprises disposing a first shielding metal at a front side (112) of the cabinet (100), the first shielding metal defining a first distance with respect to the at least one radiation source (172-176); and wherein the step of providing a second shielding material (154; 166, 168) comprises disposing a second shielding metal adjacent to the first shielding metal at the front side (112) of the cabinet (100), and the second shielding metal defines a second distance with respect to the at least one radiation source (172-176), and the first distance is larger than the second distance.

13. An electromagnetic shielding structure (140; 150; 160) for shielding at least a part of electromagnetic radiations generated from at least one electromagnetic radiation source (172-176), the electromagnetic shielding structure (140; 150; 160) comprising:

a first shielding material (152; 162, 164), for example comprising steel material, the first shielding material (152;

162, 164) being disposed at a first location with respect to the at least one radiation source (172-176); and a second shielding material (154; 166, 168), for example comprising copper or aluminum material, the second shielding material (154; 166, 168) being attached with the first shielding material (152; 162, 164) by fastening means (155-157), the second shielding material (154; 166, 168) disposed at a second location with respect to the at least one electromagnetic radiation source (172-176) and defining a predetermined gap between the first shielding material (152; 162, 164) and the second shielding material (154; 166, 168);
wherein the first shielding material (152; 162, 164) is configured for shielding at least a part of first frequency range electromagnetic radiations generated from the at least one electromagnetic radiation source (172-176) and penetrating through the second shielding material (154; 166, 168) and the predetermined gap; and
wherein the second shielding material (154; 166, 168) is configured for shielding at least a part of second frequency range electromagnetic radiations generated from the at least one electromagnetic radiation source (172-176).

14. The electromagnetic shielding structure (140; 150; 160) of claim 13, wherein the electromagnetic shielding structure (140; 150; 160) is disposed at a front side (112) of a cabinet (100) for accommodating a converter (126) therein, the first shielding material (152; 162, 164) is configured for absorbing the first frequency electromagnetic radiations having a relatively low frequency value, and the second shielding material (154; 166, 168) is configured for absorbing the second frequency electromagnetic radiations having a relatively high frequency value.

15. The electromagnetic shielding structure of claim 13 or claim 14, wherein the second shielding material (154; 166, 168) is made from high conductivity and low permeability material.

FIG. 1

FIG. 2

FIG. 3

EP 2 704 547 A2

FIG. 4

EP 2 704 547 A2

FIG. 5

EP 2 704 547 A2

EP 2 704 547 A2

FIG. 6

FIG. 7

400 ⌇

EP 2 704 547 A2

Providing a first shielding metal at one side of a cabinet for absorbing first frequency electromagnetic radiations generated from the at least one electromagnetic radiation source

402

providing a second shielding material which is disposed adjacent to the first shielding metal for absorbing second frequency electromagnetic radiations generated from the at least one electromagnetic radiation source

404

FIG. 8